# EUROPÄISCHE PATENTSCHRIFT

(11) **EP 1 541 000 B1**
(45) Veröffentlichungstag und Bekanntmachung des Hinweises auf die Patenterteilung: **16.04.2008**
(21) Anmeldenummer: 03794839.5
(22) Anmeldetag: 24.07.2003
(51) Int. Cl.: H05K 5/06, H05K 7/14

(54) **GEHÄUSE UND FELDGERÄT**
HOUSING AND FIELD DEVICE
BOITIER ET APPAREIL DE TERRAIN

(30) Priorität: 10.09.2002 DE 10242178
(43) Veröffentlichungstag der Anmeldung: 15.06.2005
(73) Patentinhaber: SEW-EURODRIVE GMBH & CO., D-76646 Bruchsal (DE)
(72) Erfinder: SCHMIDT, Josef, 76676 Graben-Neudorf (DE); BECKER, Günter, 76684 Östringen (DE); SCHÖPFER, Claus, 69168 Wiesloch (DE); SCHWESINGER, Klaus, 76646 Bruchsal (DE)
(86) Internationale Anmeldenummer: PCT/EP2003/008126
(87) Internationale Veröffentlichungsnummer: WO 2004/026013

(56) Entgegenhaltungen:
- DE-A- 19 905 952
- DE-U- 20 005 084
- US-A- 3 429 980
- US-A- 4 327 530
- US-A- 5 065 278
- US-A- 5 942 728

## Beschreibung

Die Erfindung betrifft eine Gehäuse und ein Feldgerät.

Elektrische Geräte, die in industriellen Anlagen im Feld eingesetzt werden, sind auch Schmutz, Staub, Wasser und anderen Stoffen ausgesetzt. Dies führt häufig zu Ausfällen.

Aus der US 3 429 980 A ist ein Gehäuse bekannt, das ein als Haube ausgeführtes Gehäuseteil umfasst, wobie die Haube in einer Richtung eine Öffnung aufweist.

Aus der US 5 942 728 A ist ein wasserdichtes Gehäuse bekannt.

Aus der DE 200 05 084 U ist eine Gehäusesteckverbindung mit erhöhtem Feuchtschutz bekannt.

Aus der DE 199 05 952 A ist ein Verteilerkasten für die dezentrale Technik bekannt.

Der Erfindung liegt daher die Aufgabe zugrunde, ein Gehäuse weiterzubilden, das gegen Staub, Schmutz und Wasser und andere Stoffe geschützt ist.

Erfindungsgemäß wird die Aufgabe bei dem Gehäuse nach den in Anspruch 1 angegebenen Merkmalen und bei dem Feldgerät nach den in Anspruch 12 angegebenen Merkmalen gelöst.

Wichtige Merkmale bei dem Gehäuse sind, dass das Gehäuse für ein Feldgerät vorgesehen ist, das ein als Haube ausgeführtes Gehäuseteil, einen Elektronikeinsatz und eine Anschlussbox umfasst,
wobei die Haube eine nach unten gerichtete Öffnung aufweist und einteilig ausgeführt ist und die Seitenwände der Anschlussbox formschlüssig mit den Innenwänden der Haube verbunden sind,
wobei der Elektronikeinsatz in der Haube vormontiert ist und dann auf die Anschlussbox aufsteckbar ist,
dass die Gehäuseunterseite mit Hilfe der Anschlussbox über den Dichtheit bewirkenden Formschluss zur Haube mit zusätzlicher Dichtung geschützt ist,
dass die Staubdichtigkeit der Haube mit dem montierten Elektronikeinsatzdurch den Formschluss des Elektronikeinsatzes mit der Haube und eine Dichtung gegeben ist.

Von Vorteil ist dabei, dass eine schnell und einfach auszuführende Montage ermöglicht ist, Dichtheit vorhanden ist und das Gehäuse sowie das dreiteilige Feldgerät kostengünstig herstellbar sind. Außerdem ist die Montage und Wartung besonders einfach und kostengünstig ausführbar. Wesentlich ist auch, dass bei einem eventuellen Austausch von defekten Komponenten dieser Austausch besonders einfach und schnell ausführbar ist. Dabei ist zu beachten, dass ein solcher Austausch nicht nur mechanisch sondern auch datentechnisch auszuführen ist. Wegen des mindestens dreigeteilten Aufbaus ist bei der Erfindung der Parametrieraufwand, der nach einem Austausch von Elektronikkomponenten notwendig ist, deutlich verringerbar. Denn die Gehäusekonstruktion ist insbesondere zumindest dreiteilig ausgeführt, wobei die Haube mit Elektronikeinsatz bei Defekt schnell mechanisch austauschbar ist und wobei im stationären Unterteil, welches im Wesentlichen die Anschlussvorrichtungen für elektrisch zu verbindende Geräte umfasst, ein Datenspeicher vorsehbar ist, der die kennzeichnenden Daten, Parameter oder auch nur eine kennzeichnende Adresse vorrätig und abrufbar hält. Schon aus der Adressinformation allein ist der Elektronikeinsatz in der Lage, über einen Datenbus die in einem Zentralrechner abgelegten Parameter und weiteren Parametrierdaten abzurufen und somit seine eigene Parametrierung selbsttätig auszuführen. Somit sind wesentliche Zeiteinsparungen erreichbar, insbesondere im Vergleich zum Stand der Technik, bei welchem Feldgeräte eine speziell vorgesehene Schnittstelle aufweisen müssen, über die Daten beim Parametrieren einzuspielen sind.

Bei weiteren erfindungsgemäßen Ausführungsformen ist das Gehäuse einstückig ausgeführt ist. Somit ist eine hohe Schutzart und eine besonders hohe Dichtheit erreichbar.

Bei weiteren erfindungsgemäßen Ausführungsformen weist die Haube nur nach unten, also in Schwerkraftrichtung, eine oder mehrere Öffnungen auf. Somit kann kein Wasser zum Elektronikeinsatz gelangen, auch wenn die gesamte Anlage Hochwasser ausgesetzt ist.

Bei weiteren erfindungsgemäßen Ausführungsformen ist die Haube derart geformt, dass der Abfluss von Wasser, insbesondere unter Einwirkung der Gravitationskraft, erfolgt, ohne dass Wasser sich an einer Stelle an der Haube ansammeln kann. Somit ist vorteiligerweise die Korrosionsgefahr vermindert.

Bei weiteren erfindungsgemäßen Ausführungsformen ist die Haube durch Tiefziehen, insbesondere aus Blech, oder mittels Druckguss oder mittels Spritzguss gefertigt. Somit ist die Haube kostengünstig fertigbar.

Bei weiteren erfindungsgemäßen Ausführungsformen umfasst die Haube einen unteren und einen oberen Haubenteil, wobei der obere Haubenteil mit einem Rippenprofil, insbesondere zur Bildung eines Kühlkörpers und/oder zur verbesserten Abfuhr von Wärme an die Umgebung, ausgeführt ist. Somit sind sogar eine oder mehrere elektronische Schaltungen, die als Umrichter einen Motor versorgen, können im Elektronikeinsatz integrierbar.

Bei weiteren erfindungsgemäßen Ausführungsformen sind das untere und das obere Haubenteil einstückig ausgeführt. Von Vorteil ist somit, dass eine hohe Dichtheit und hohe Schutzart erreichbar sind.

Bei weiteren erfindungsgemäßen Ausführungsformen ist der Elektronikeinsatz mit der Innenseite der Haube dicht verbunden. Von Vorteil ist dabei, dass die Haube zusammen mit dem Elektronikeinsatz im Wartungs- oder Reparaturfall schnell austauschbar ist. Die rein mechanischen Anschlussvorrichtungen befinden sich hingegen in der Anschlussbox (30) und müssen somit bei defektem Elektronikeinsatz nicht ausgetauscht werden. Somit sind Kosten einsparbar.

Bei weiteren erfindungsgemäßen Ausführungsformen weist der Elektronikeinsatz zur Anschlussbox eine Steckverbindereinheit auf. Von Vorteil ist dabei, dass ein schnelles und Einfaches Verbinden ermöglicht ist.

Bei weiteren erfindungsgemäßen Ausführungsformen ist die Steckverbindereinheit abgedichtet ausgeführt. Insbesondere weist die Steckverbindereinheit eingespritzte Kontaktstifte zur Dichtfunktion auf, wobei die Steckverbindereinheit mittels einer Dichtung zum Elektronikeinsatz verbunden ist. Somit ist das der Elektronikeinsatz in hoher Schutzart abgedichtet vorsehbar.

Bei weiteren erfindungsgemäßen Ausführungsformen umfasst das Gehäuse mindestens einen Elektronikeinsatz und mindestens eine Anschlussbox. Insbesondere ist der Elektronikeinsatz mittels Kraftschluss mit der Haube, insbesondere mit deren oberen Teil, verbindbar. Somit ist in besonders einfacher und kostengünstiger Weise der Elektronikeinsatz und die Haube sogar abgedichtet verbindbar. Insbesondere ist auch eine zusätzliche Dichtung zwischen Haube und Elektronikeinsatz vorsehbar.

Bei weiteren erfindungsgemäßen Ausführungsformen ist der Elektronikeinsatz form- und kraftschlüssig mit einer Montagehalterung verbunden, die vom oberen Teil der Haube umfasst ist. Somit sind nicht nur Boden- sondern auch Wandmontagen vorsehbar.

Bei weiteren erfindungsgemäßen Ausführungsformen weist der Elektronikeinsatz erste Steckverbinder, also Steckverbindereinheiten, auf in Schwerkraftrichtung. Insbesondere weist die Anschlussbox zweite Steckverbinder, also entsprechende Steckverbindereinheiten, zur Verbindung mit den ersten Steckverbindern auf.

Bei weiteren erfindungsgemäßen Ausführungsformen weist die Anschlussbox Öffnungen für Kabelzuführung an der unteren Seite, also in Schwerkraftrichtung, auf. Vorteiligerweise sind also diese Kabelzuführungen auch von der Haube gegen zumindest senkrecht einfallenden Regen schützbar. Dazu ist die Haube an ihrem unteren Rand über die Anschlussbox vorgezogen ausführbar und damit der Regenschutz verbesserbar.

Bei weiteren erfindungsgemäßen Ausführungsformen ist die Anschlussbox formschlüssig und dicht mit der Haube verbunden, insbesondere mittels einer zwischengeordneten Dichtung. Insbesondere weist der Elektronikeinsatz zumindest zwei Dichtungen zur dichten Verbindung mit der Haube auf, nämlich an seinem Umfang und an dem Steckverbinder.

Bei weiteren erfindungsgemäßen Ausführungsformen ist das Feldgerät für den dezentralen Einsatz in einer industriellen Anlage ausgeführt ist. Somit ist das Feldgerät mit einem Elektronikeinsatz, der PC-Funktionalität umfasst, ausführbar und im Feld, also beispielsweise auch im Nassbereich, installierbar und betreibbar. Statt der PC-Funktionalität ist auch Umrichterfunktionalität zur Versorgung von Elektromotoren im Elektronikeinsatz integrierbar. Die Wärme der Leistungsendstufe des Umrichters ist dann über die insbesondere mit Kühlrippen ausgestattete Haube an die Umgebung abführbar.

Weitere Vorteile ergeben sich aus den Unteransprüchen.

### Bezugszeichenliste

- 11: Haube
- 12: Montagehalterung
- 13: Montageplatte
- 14: Wand
- 20: Elektronikeinsatz
- 21: erste Steckverbinder
- 22: Dichtung
- 29: Gewindestangen
- 30: Anschlussbox
- 31: zweite Steckverbinder
- 32: formschlüssiger Bereich.
- 33: Dichtungen
- 34: Schnellverschluss
- 35: Gehäuseunterseite
- 36: Kabelzuführung
- 37: Kühlrippen
- 38: Seitenplatte
- 41: Haube
- 42: Kühlrippen
- 43: Montageplatte
- 44: Befestigungsschraube
- 45: klappbares Gehäuseteil der Anschlussbox
- 46: Führungsschiene
- 47: Steckverbindereinheit
- 48: PG-Verschraubungen für Niederspannung
- 49: PG-Verschraubungen für Leistungsversorgung
- 50: unteres Gehäuseteil der Anschlussbox
- 51: weiteres Gehäuseteil der Anschlussbox
- 52: Anschlussvorrichtungen
- 61: Haube
- 62: Geräteschalter
- 63: weiteres Gehäuseteil der Anschlussbox
- 64: Gehäuseteil

Die Erfindung wird nun anhand von Abbildungen näher erläutert:
In der Figur 1 ist das Feldgerät in Wandmontage gezeigt.
In der Figur 2 ist das Feldgerät in Explosionszeichnung gezeigt, wobei die Anschlussbox, der Elektronikeinsatz und das als Haube ausgeführte Gehäuseteil zu sehen sind.
In der Figur 3 ist die Haube gezeigt.

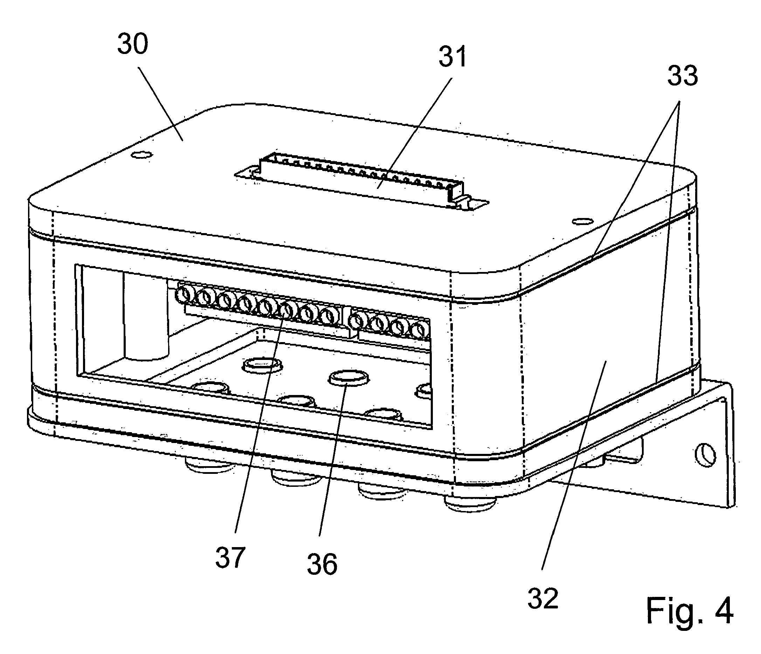

In der Figur 4 ist die Anschlussbox mit seitlich abgehobener Seitenplatte gezeigt.

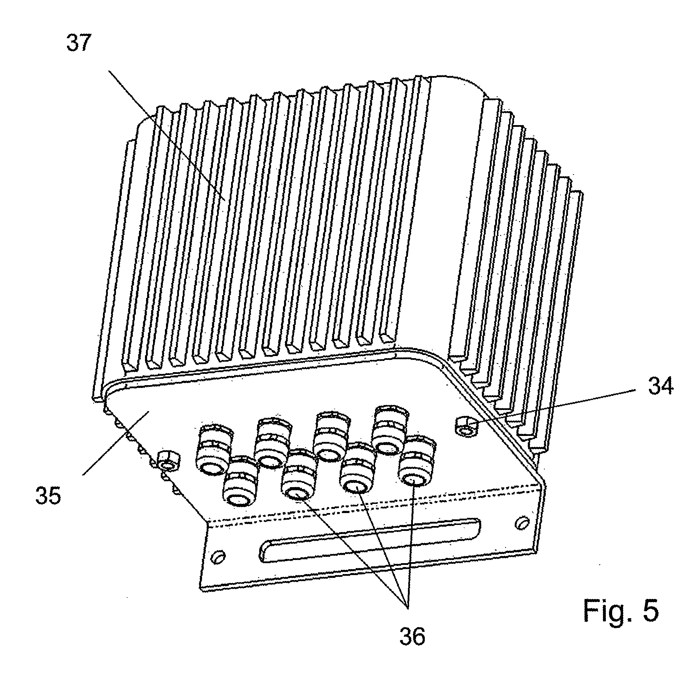

In der Figur 5 ist das Feldgerät aus einem andern Winkel gezeigt.
In der Figur 6 ist der Elektronikeinsatz gezeigt.
In den Figuren 20 bis 22 ist ein weiteres erfindungsgemäßes Ausführungsbeispiel schematisch gezeigt. Dabei ist in der Figur 20 das Feldgerät gezeigt. In der Figur 21 ist die Haube 41 abgehoben gezeigt. In der Figur 22 ist ein Gehäuseteil aufgeklappt gezeigt.
In den Figuren 23 und 24 ist ein weiteres ähnliches erfindungsgemäßes Ausführungsbeispiel gezeigt, wobei ein Geräteschalter vorgesehen ist.

Das Feldgerät weist eine Gehäusekonstruktion in hoher Schutzart auf und ist daher besonders für die Installation von dezentraler Steuerungstechnik im Feld einer industriellen Anlage geeignet.

Das Feldgerät weist einen zumindest dreiteiligen Aufbau der Gesamtkonstruktion, umfassend ein Gehäuseteil, das als Haube 11 ausgeführt ist, einen Elektronikeinsatz 20 und eine Anschlussbox 30 auf. Die Anschlussbox 30 hat zusätzlich nach unten, also in Schwerkraftrichtung gerichtete, gehäusebildende Funktion.

Die elektronische Schaltung ist als Umrichterelektronik ausgeführt. Bei weiteren erfindungsgemäßen Ausführungsbeispielen sind auch andere elektronische Schaltungen vorsehbar, beispielsweise Steuerungselektronik, Motorschaltfunktionselektronik oder Sanftanlaufgerätselektronik.

Dabei ist die Haube 11 einteilig ausgeführt und weist keine Öffnung nach oben oder in Seitenrichtung auf. Nur nach unten, also in Schwerkraftrichtung, ist eine Öffnung vorgesehen. Somit kann beispielsweise bei Hochwasser nur ein gewisser Teil des Innenvolumens im unteren Bereich des unteren Haubenteils geflutet werden, falls Dichtungen und weitere vorgesehene Maßnahmen versagen sollten.

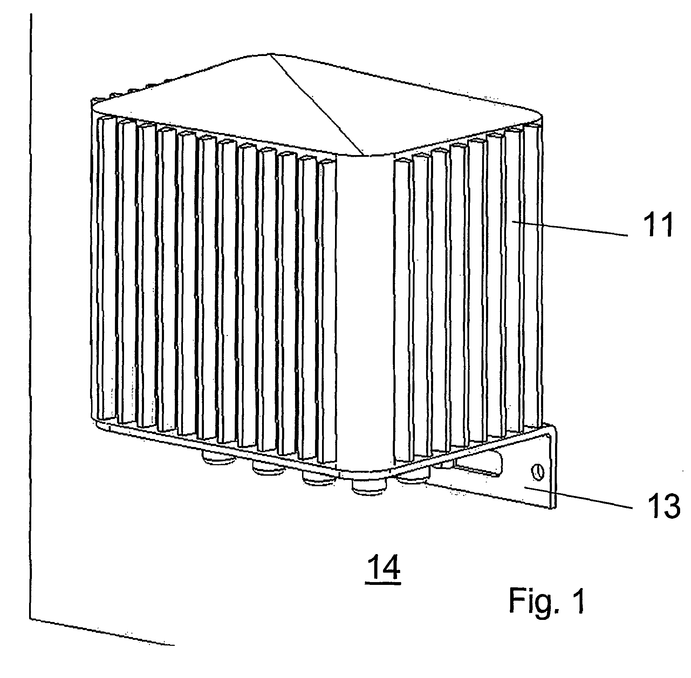

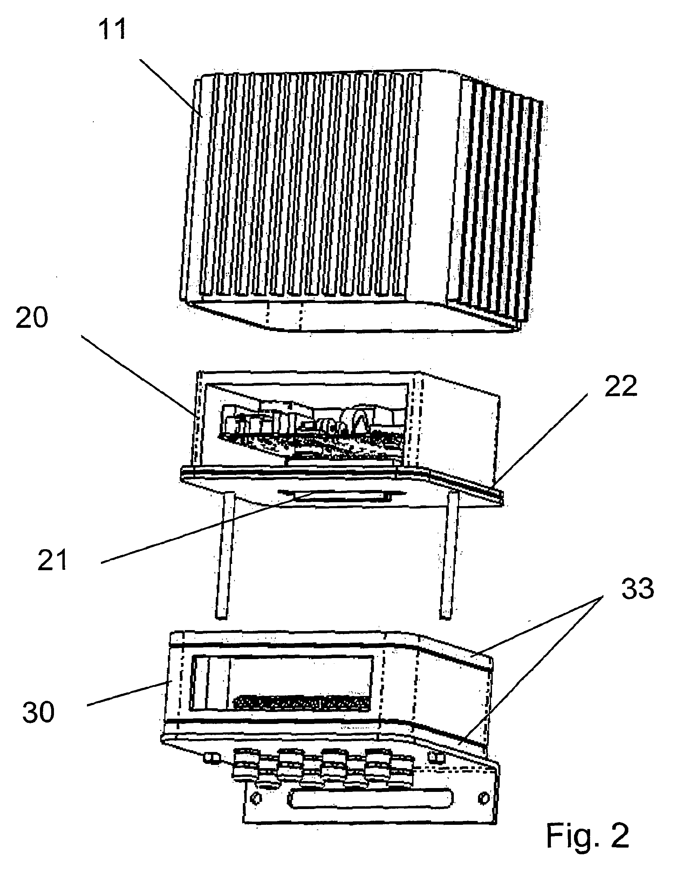

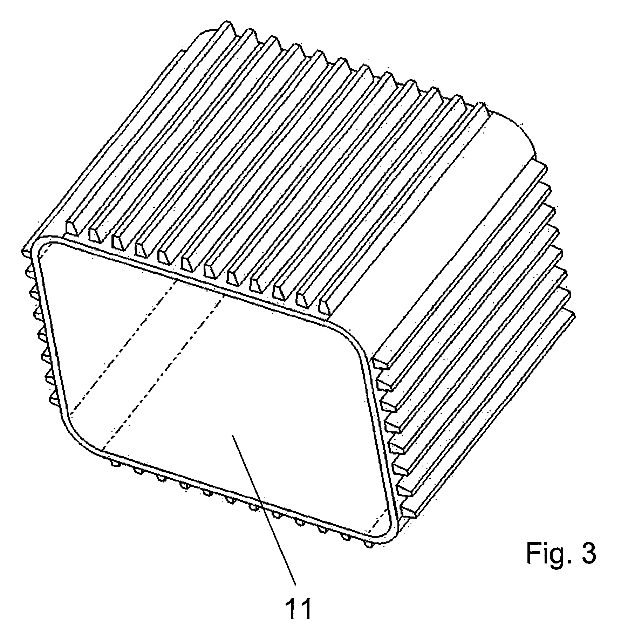

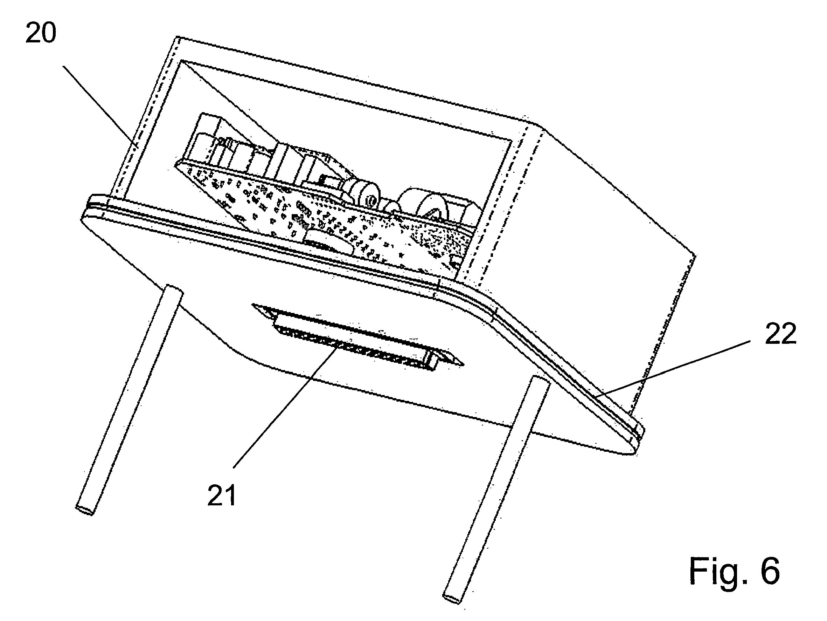

Die Haube 11 ist aus Blech tiefgezogen, in Druckguss oder in Spritzguss gefertigt. Die Haube 11 ist zumindest in ihrem oberen Teil mit einem Rippenprofil zur Kühlung der Elektronik versehen. In dem erfindungsgemäßen Ausführungsbeispiel gemäß den Figuren 1,2,3,6 ist das Rippenprofil über die gesamte Länge der Haube ausgeführt.

In weiter verbesserten erfindungsgemäßen Ausführungsbeispielen ist die Haube stets derart geformt und die Kühlrippen derart ausgeführt und Montagerichtung gewählt, dass Wasser oder andere Flüssigkeiten außen an der Haube ungestört abfließen können. Es sind also keinerlei Mulden oder dergleichen vorhanden, wo sich Wasser ansammeln könnte. Somit ist der Korrosionsschutz erhöht.

Der Elektronikeinsatz 20 umfasst eine elektronische Schaltung und ist mittels Gewindestangen 29 an der Anschlussbox 30 und mit Muttern 34 befestigt. Bei weiteren erfindungsgemäßen Ausführungsformen ist auch eine Befestigung mittels Kraftschluss ausführbar, insbesondere auch in der oberen Haubenhälfte. Insbesondere ist auch ein Bajonett-Verschluss vorteilig einsetzbar.

Der Wärmetransport wird zumindest über Form- und/oder Kraftschluss an die Haube 11 gewährleistet. Eine zusätzliche Verschraubung ist optional möglich. Die Kontaktierung erfolgt über die Steckverbindung 21.

Die Anschlussbox 30 ist mit dem Elektronikeinsatz 20 mittels einer Steckverbindung verbunden, die aus dem ersten Steckverbinder 21 und dem zweiten Steckverbinder 31 gebildet ist.

Der Elektronikeinsatz kann auch Dichtungen 22 aufweisen zum Herstellen einer dichten Verbindung mit der Haube.

Die Kabelzuführung 36 zum Elektronikeinsatz 20 ist an der Unterseite der Anschlussbox 30 vorgesehen. Je nach Schutzart und Anforderung ist die Kabelzuführung 36 bei weiteren erfindungsgemäßen Ausführungsbeispielen über Steckverbinder oder PG-Verschraubung von unten ausgeführt. In den Figuren sind PG-Verschraubungen 36 in der Gehäuseunterseite 35 der Anschlussbox gezeigt.

Die Seitenwände der Anschlussbox sind formschlüssig, also passgenau, mit den Innenwänden der Haube 11 verbunden. Dieses Verbinden schafft eine gewisse Dichtigkeit gegen beispielsweise Staub und der gleichen. Die Dichtigkeit zur Erreichung hoher Schutzart wird mittels Dichtungen 33 erreicht.

Bei weiteren erfindungsgemäßen Ausführungsbeispielen ist von unten in die Anschlussbox 30 optional ein Wartungsschalter integriert.

Die Befestigung der Anschlussbox 30 ist über eine integrierte Montagehalterung vorgesehen. Die Kabelführung für die elektrischen Anschlüsse ist von unten durch die Montagehalterung 13 geführt. Bei weiteren erfindungsgemäßen Ausführungsbeispielen ist sie auch seitlich herausführbar. Die Montagehalterung 13 weist auch ein Langloch auf zur weiteren optionalen Kabeldurchführung.

Die Montage erfogt nach Fertigen des Elektronikeinsatzes 20 durch Vormontieren desselben in die Haube, die dann auf die Anschlussbox aufsteckbar ist.

Die Kontaktierung erfolgt über die ersten und zweiten Steckverbinder (21, 31). Eine Verschraubung der Anschlussbox 30 mit der Haube erfolgt von unten über einen Schnellverschluss 34. Insbesondere ist dazu ein Bajonettverschluss vorteilhaft einsetzbar.

Zum Herstellen der Dichtigkeit ist die Montagelage der Haube derart ausgeführt, dass die Haube nach unten, also in Schwerkraftrichtung montiert ist. Dadurch wird ein Abtropfen jeglicher Flüssigkeit von oben und von allen vier Seiten über die Haube sichergestellt. Über dieses Prinzip ist auch die Anschlussbox 30 geschützt. Nur die Unterseite für die Kabelzuführung kann beispielsweise bei Hochwasser mit Flüssigkeit in Berührung kommen.

Die Gehäuseunterseite 35 wird mit Hilfe der Anschlussbox 30 über den Dichtheit bewirkenden Formschluss 32 zur Haube und zwei zusätzliche Dichtungen 33 geschützt.

Die Staubdichtigkeit der Haube mit montierter Elektronik 20 ist durch den Formschluss des Elektronikeinsatzes mit der Haube und die Dichtfläche 22 gegeben. Somit ist die Elektronik auch im demontierten Zustand geschützt.

Die Anschlussbox 30 ist selbst staubdicht ausgeführt.

Die Wärme der Elektronischen Schaltung des Elektronikeinsatzes wird über den oberen Haubenteil 11 und die dort eingeprägten Kühlrippen abgeführt. Der untere Haubenteil 10 bleibt kühler.

Der Ablauf von Kondenswasser in der Anschlussbox kann über den konstruktiven Aufbau sichergestellt werden. Die Anschlussklemmen 37 sind räumlich getrennt von der Kondenswassersammelstelle angebracht.

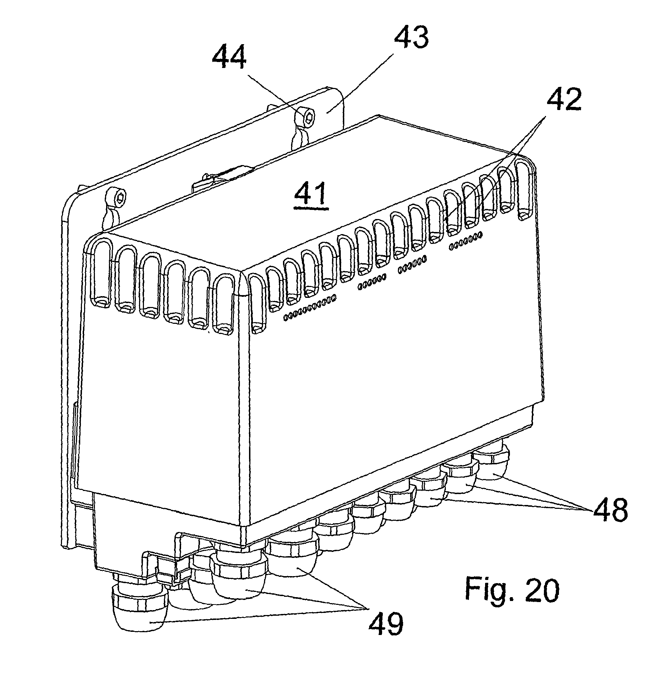

In den Figuren 20 bis 22 ist ein weiteres erfindungsgemäßes Ausführungsbeispiel schematisch gezeigt.

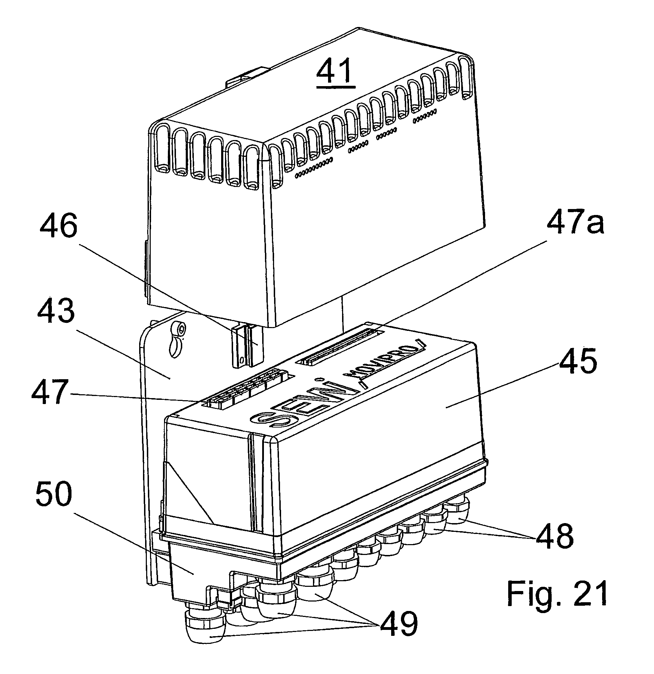

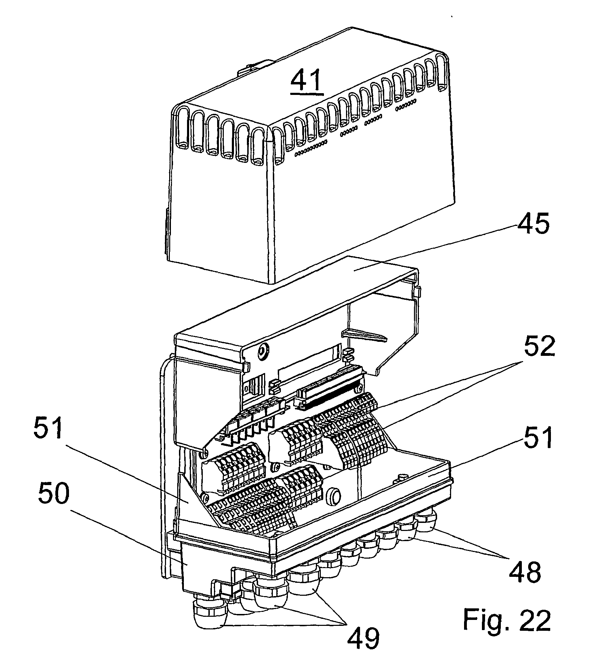

Dabei ist in der Figur 20 das Feldgerät gezeigt. In der Figur 21 ist die Haube 41 abgehoben gezeigt, wobei ein Elektronikeinsatz in der Haube mit dieser verbunden ist. In der Figur 22 ist ein Gehäuseteil aufgeklappt gezeigt.

Dabei ist die Haube 41 mit Kühlrippen 42 versehen, die in den Figuren nur angedeutet sind. Dabei sind diese so geformt, dass das Wasser stets ablaufen kann und nirgends stehen bleibt.

Bei weiteren erfingungsgemäßen Ausführungsbeispielen verlaufen die Kühlrippen 42 von oben nach unten ganz durch.

In den Figuren 20 bis 22 ist das Feldgerät mit seiner mit der Anschlussbox verbundenen Montageplatte 43 und den in deren Ausnehmungen durchgeführten Befestigungsschraube 44 an einer Wand befestigbar. Die Montageplatte 43 weist außerdem eine Führungsschiene 46 auf, die das Aufsetzen der Haube 41 des Feldgerätes vereinfacht und erleichtert.

Die Anschlussbox ist aus einem unteren Gehäuseteil 50 , einem auf diesem aufgesetzten weiteren Gehäuseteil 51 und einem daran drehbar, also aufklappbar, verbundenen Gehäuseteil 45.

Die Anschlussbox weist Steckverbindereinheiten 47 und 47a auf, mittels derer die in der Anschlussbox sich befindenden Anschlussvorrichtungen 52 elektrisch verbindbar sind mit dem Elektronikeinsatz, welcher sich bei den Figuren 20 bis 22 schon innerhalb der Haube 41 befindet. Der Elektronikeinsatz weist entsprechende Steckverbindereinheiten auf, die abdgedichtet ausgeführt sind. Insbesondere weist die Steckverbindereinheit eingespritzte Kontaktstifte auf, wobei die Steckverbindereinheit mittels einer Dichtung zum Elektronikeinsatz verbunden ist.

Die Anschlussbox weist an ihrem unteren Gehäuseteil 50 angebrachte PG-Verschraubungen 48 für Niederspannung und PG-Verschraubungen 49 für Leistungsversorgung auf. Somit sind von anderen Geräten stammende Kabel mit den Anschlussvorrichtungen 52 dicht verbindbar.

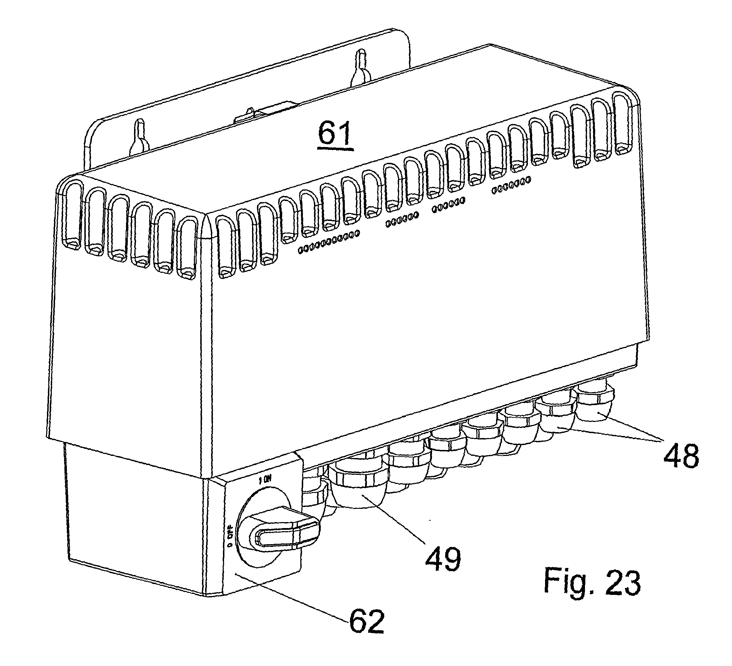

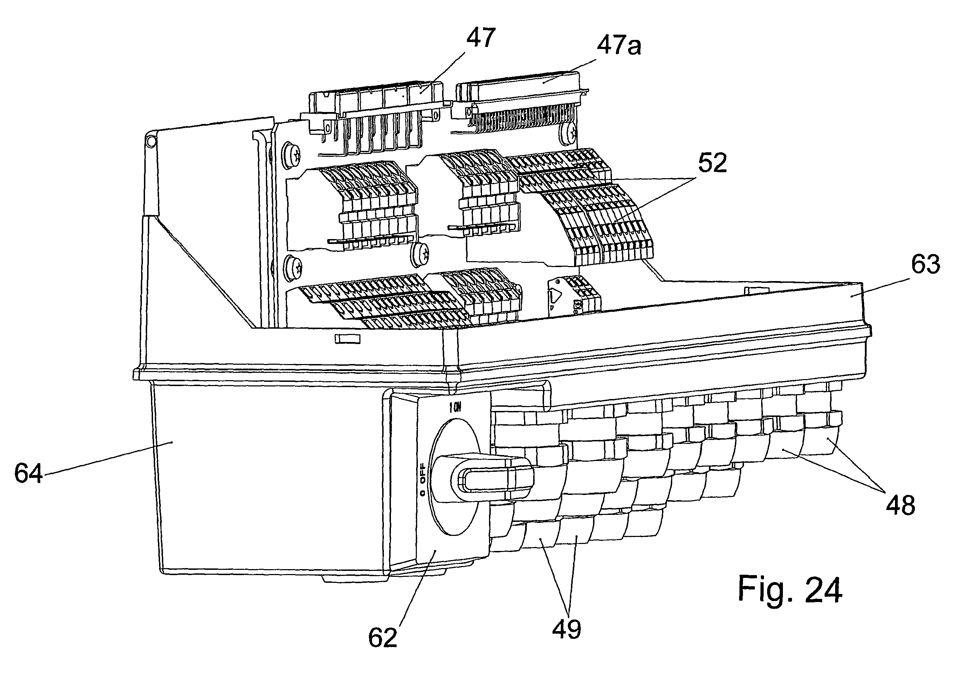

In den Figuren 23 und 24 ist ein weiteres ähnliches erfindungsgemäßes Ausführungsbeispiel gezeigt. Dabei ist an der Anschlussbox ein Geräteschalter 62 mit einem Gehäuseteil 64 angebracht, das mit dem weiteren Gehäuseteil 63 der Anschlussbox des Feldgerätes verbunden ist. Dabei ist der Schalter dicht ausgeführt, also in hoher Schutzart und wasserdicht. Die Schutzart kann auch IP64 oder höher sein. Dies restlichen Komponenten und ähneln den Komponenten des Ausführungsbeispiel nach Figur 20 bis 22. Der Geräteschalter ist auch besonders für Wartungen geeignet.

Der Elektronikeinsatz ist auch mit Umrichterfunktionalität ausführbar. Dabei ist die Leistungselektronik wärmeleitend mit der Haube verbunden, wobei die Wärme über die Kühlrippen abführbar ist. Der elektrisch über die Anschlussvorrichtungen der Anschlussbox mit dem Elektronikeinsatz verbundene Elektromotor wird von der Umrichterschaltung des Elektronikeinsatzes versorgt. Des Weiteren weist der Elektronikeinsatz Anschlüsse für Ein- und Ausgänge auf, womit Sensoren und/oder Aktoren über die Anschlussvorrichtungen der Anschlussbox verbindbar sind. Darüber hinaus sind auch Versorgungsleitungen, wie 24 V, und Feldbus-Leitungen anschließbar. Feldbusleitungen, Leistungsversorgungsleitungen, also Starkstromleitungen, und Versorgungsleitungen, insbesondere 24 V Leitungen, sind in der Anschlussbox T-förmig verkabelt. Somit sind weitere Feldgeräte seriell elektrisch verbindbar.

In der Anschlussbox ist auch elektronischer langzeitstabiler Datenspeicher vorgesehen, beispielsweise ein EEPROM. Somit ist eine Adresse abspeicherbar und der Elektronikeinsatz kann sich die für diese Adresse bestimmten Daten bei der Inbetriebnahme und Parametrierung über den Feldbus von einer zentralen Steuerung holen und ist somit schnell und einfach parametrierbar. Es sind auch Voreinstellungsinformationen in dem Datenspeicher abspeicherbar.

Die Anschlussbox ist stets mit der Anlage fest und/oder lösbar verbindbar. Es muss also bei Elektronikfehlern nur die Haube samt Elektronikeinsatz ausgetauscht werden.

Ein weiterer Vorteil der Anschlussbox ist, dass je nach Kunde und Anlage eine für diese Anlage spezifische Verdrahtung fest vorgebbar ist. Somit ist das immer gleiche Feldgerät für verschiedene Anlagen mit den zugehörigen Verdrahtungen lieferbar. Dazu ist die Anschlussbox auch mit einer Rangierplatine zwischen der Anschlussleiste für die Anschlussvorrichtungen und den PG-Verschraubungen ausführbar.

## Patentansprüche

1. Gehäuse für ein Feldgerät, insbesondere für den dezentralen Einsatz in einer industriellen Anlage,
das ein als Haube (11) ausgeführtes Gehäuseteil, einen Elektronikeinsatz (20) und eine Anschlussbox (30 umfasst,
wobei die Haube (11) eine nach unten gerichtete Öffnung aufweist und einteilig ausgeführt ist und die Seitenwände der Anschlussbox formschlüssig mit den Innenwänden der Haube (11) verbunden sind,
**dadurch gekennzeichnet, dass**
der Elektronikeinsatz (20) in der Haube (11) vormontiert ist und dann auf die Anschlussbox (30) aufsteckbar ist,
dass die Gehäuseunterseite mit Hilfe der Anschlussbox (30) über den Dichtheit bewirkenden Formschluss (32) zur Haube mit zusätzlicher Dichtung (33) geschützt ist,
dass die Staubdichtigkeit der Haube (11) mit dem montierten Elektronikeinsatz(20) durch den Formschluss des Elektronikeinsatzes (20) mit der Haube (11) und eine Dichtung (22) gegeben ist.

2. Gehäuse nach Anspruch 1,
**dadurch gekennzeichnet, dass**
die Haube (11) derart geformt ist, dass der Abfluss von Wasser, insbesondere unter Einwirkung der Gravitationskraft, erfolgt, ohne dass Wasser sich an einer Stelle an der Haube (11) ansammeln kann

3. Gehäuse nach Anspruch 1 oder 2,
**dadurch gekennzeichnet, dass**
die Haube (11) durch Tiefziehen, insbesondere aus Blech, oder mittels Druckguss oder mittels Spritzguss gefertigt ist.

4. Gehäuse nach mindestens einem der vorangegangenen Ansprüche,
**dadurch gekennzeichnet, dass**
die Haube (11) einen unteren und einen oberen Haubenteil umfasst,
wobei der obere Haubenteil mit einem Rippenprofil, insbesondere zur Bildung eines Kühlkörpers und/oder zur verbesserten Abfuhr von Wärme an die Umgebung, ausgeführt ist.

5. Gehäuse nach mindestens einem der vorangegangenen Ansprüche,
**dadurch gekennzeichnet, dass**
der Elektronikeinsatz (20) mit der Innenseite der Haube (11), insbesondere dem oberen Haubenteil, dicht verbunden ist.

6. Gehäuse nach mindestens einem der vorangegangenen Ansprüche,
**dadurch gekennzeichnet, dass**
der Elektronikeinsatz (20) zur Anschlussbox (30) eine Steckverbindereinheit aufweist

7. Gehäuse nach mindestens einem der vorangegangenen Ansprüche,
**dadurch gekennzeichnet, dass**
die Steckverbindereinheit abgedichtet ausgeführt ist

8. Gehäuse nach mindestens einem der vorangegangenen Ansprüche,
**dadurch gekennzeichnet, dass**
die Steckverbindereinheit eingespritzte Kontaktstifte zur Dichtfunktion aufweist

9. Gehäuse nach mindestens einem der vorangegangenen Ansprüche,
**dadurch gekennzeichnet, dass**
die Steckverbindereinheit mittels einer Dichtung zur Anschlussbox (30) verbunden ist

10. Gehäuse nach mindestens einem der vorangegangenen Ansprüche,
**dadurch gekennzeichnet, dass**
die Anschlussbox (30) mindestens einen elektronischen Datenspeicher umfasst

11. Gehäuse nach mindestens einem der vorangegangenen Ansprüche,
**dadurch gekennzeichnet, dass**
der elektronische Datenspeicher derart ausgeführt ist, dass Daten, insbesondere Adressdaten, dauerhaft, insbesondere langzeitstabil, abspeicherbar sind.

12. Feldgerät mit einem Gehäuse nach mindestens einem der vorangegangenen Ansprüche,
wobei das Feldgerät für den dezentralen Einsatz in einer industriellen Anlage ausgeführt ist und das Gehäuse mindestens einen Elektronikeinsatz (20) und mindestens eine Anschlussbox (30) umfasst,
wobei der Elektronikeinsatz (20) erste Steckverbinder aufweist in Schwerkraftrichtung.

13. Feldgerät nach Anspruch 12,
**dadurch gekennzeichnet, dass**
der Elektronikeinsatz (20) mittels Kraftschluss mit der Haube (11), insbesondere mit deren oberen Teil, verbunden ist.

14. Feldgerät nach Anspruch 12,
**dadurch gekennzeichnet, dass**
der Elektronikeinsatz (20) form- und kraftschlüssig mit einer Montagehalterung verbunden ist, die vom oberen Teil der Haube (11) umfasst ist

15. Feldgerät nach mindestens einem der vorangegangenen Ansprüche,
**dadurch gekennzeichnet, dass**
die Anschlussbox (30) zweite Steckverbinder zur Verbindung mit den ersten Steckverbindern aufweist

16. Feldgerät nach mindestens einem der vorangegangenen Ansprüche,
**dadurch gekennzeichnet, dass**
die Anschlussbox (30) Öffnungen für Kabelzuführung an der unteren Seite, also in Schwerkraftrichtung, aufweist

17. Feldgerät nach mindestens einem der vorangegangenen Ansprüche,
**dadurch gekennzeichnet, dass**
die Anschlussbox (30) formschlüssig und dicht mit der Haube (11) verbunden ist.

18. Feldgerät nach mindestens einem der vorangegangenen Ansprüche,
**dadurch gekennzeichnet, dass**
die Anschlussbox (30) zwei Dichtungen zur dichten Verbindung mit der Haube (11) aufweist.

19. Feldgerät nach mindestens einem der vorangegangenen Ansprüche,
**dadurch gekennzeichnet, dass**
der Elektronikeinsatz (20) Umrichterfunktionalität umfasst oder mit einem Umrichter elektrisch verbunden ist.

## Claims

1. Housing for a field device, in particular for decentralised use in an industrial facility,
comprising a housing part designed as a hood (11), an electronics insert (20) and a connection box (30),
the hood (11) having a downwardly directed opening and being of one-piece design and the side walls of the connection box being connected in a form-locking manner to the interior walls of the hood (11),
**characterised in that**
the electronics insert (20) is preassembled in the hood (11) and can then be fitted onto the connection box (30),
**in that**, with the aid of the connection box (30), the bottom side of the housing is protected by the sealing, form-locking connection (32) to the hood with additional seal (33),
**in that** the hood (11) with the mounted electronics insert (20) is made impervious to dust by virtue of the form-locking connection of the electronics insert (20) to the hood (11) and a seal (22).

2. Housing according to Claim 1,
**characterised in that**
the hood (11) is shaped such that water runs off, in particular under the influence of the gravitational force, without being able to collect in one place on the hood (11).

3. Housing according to Claim 1 or 2,
**characterised in that**
the hood (11) is produced by deep drawing, in particular from sheet metal, or by pressure diecasting or by injection moulding.

4. Housing according to at least one of the preceding claims,
**characterised in that**
the hood (11) comprises a lower and an upper hood part, the upper hood part being designed with a ribbed profile, in particular for forming a heat sink and/or for improved dissipation of heat to the environment.

5. Housing according to at least one of the preceding claims,
**characterised in that**
the electronics insert (20) is imperviously connected to the inner side of the hood (11), in particular the upper hood part.

6. Housing according to at least one of the preceding claims,
**characterised in that**
the electronics insert (20) has a plug-in connector unit to the connection box (30).

7. Housing according to at least one of the preceding claims,
**characterised in that**
the plug-in connector unit is designed in a sealed manner.

8. Housing according to at least one of the preceding claims,
**characterised in that**
the plug-in connector unit has moulded-in contact pins for the sealing function.

9. Housing according to at least one of the preceding claims,
**characterised in that**
the plug-in connector unit is connected by a seal to the connection box (30).

10. Housing according to at least one of the preceding claims,
**characterised in that**
the connection box (30) comprises at least one electronic data store.

11. Housing according to at least one of the preceding claims,
**characterised in that**
the electronic data store is designed such that data, in particular address data, may be stored permanently, in particular with long-term stability.

12. Field device having a housing according to at least one of the preceding claims,
wherein the field device is designed for decentralised use in an industrial facility and the housing comprises at least one electronics insert (20) and at least one connection box (30),
the electronics insert (20) having first plug-in connectors in the direction of gravity.

13. Field device according to Claim 12,
**characterised in that**
the electronics insert (20) is connected by friction locking to the hood (11), in particular to its upper part.

14. Field device according to Claim 12,
**characterised in that**
the electronics insert (20) is connected by form locking and friction locking to a mounting support, which is encompassed by the upper part of the hood (11).

15. Field device according to at least one of the preceding claims,
**characterised in that**
the connection box (30) has second plug-in connectors for connecting to the first plug-in connectors.

16. Field device according to at least one of the preceding claims,
**characterised in that**
the connection box (30) has openings for cable entry on the bottom side, i.e. in the direction of gravity.

17. Field device according to at least one of the preceding claims,
**characterised in that**
the connection box (30) is connected to the hood (11) in a form-locking and impervious manner.

18. Field device according to at least one of the preceding claims,
**characterised in that**
the connection box (30) has two seals for impervious connection to the hood (11).

19. Field device according to at least one of the preceding claims,
**characterised in that**
the electronics insert (20) includes converter functionality or is electrically connected to a converter.

## Revendications

1. Boîtier pour un appareil de terrain, en particulier pour l'utilisation décentralisée dans une installation industrielle,
qui comprend une partie de boîtier réalisée sous forme de capot (11), un insert électronique (20) et une boîte de raccordement (30),
le capot (11) présentant une ouverture dirigée vers le bas et étant réalisé d'une seule pièce et les parois latérales de la boîte de raccordement étant reliées par liaison de forme aux parois intérieures du capot (11),
**caractérisé en ce que**
l'insert électronique (20) est prémonté dans le capot (11) et peut ensuite être enfiché sur la boîte de raccordement (30),
que la face inférieure de boîtier est protégée à l'aide de la boîte de raccordement (30) par la liaison de forme (32) assurant l'étanchéité par rapport au capot et par un joint (33) supplémentaire,
que l'étanchéité aux poussières du capot (11) avec l'insert électronique (20) monté est assurée par la liaison de forme de l'insert électronique (20) avec le capot (11) et par un joint (22).

2. Boîtier selon la revendication 1,
**caractérisé en ce que**
le capot (11) est formé de façon que l'évacuation d'eau s'effectue en particulier sous l'effet de la force de gravitation, sans que de l'eau ne puisse s'accumuler à un endroit sur le capot (11).

3. Boîtier selon la revendication 1 ou 2,
**caractérisé en ce que**
le capot (11) est réalisé par emboutissage, en particulier en tôle, ou par moulage sous pression ou moulage par injection.

4. Boîtier selon au moins l'une des revendications précédentes,
**caractérisé en ce que**
le capot (11) comprend une partie inférieure de capot et une partie supérieure de capot, la partie supérieure de capot étant réalisée avec un profil nervuré, en particulier pour former un dissipateur thermique et/ou pour une meilleure évacuation de la chaleur dans l'environnement.

5. Boîtier selon au moins l'une des revendications précédentes,
**caractérisé en ce que**
l'insert électronique (20) est relié de manière étanche à la face intérieure du capot (11), en particulier à la partie supérieure de capot.

6. Boîtier selon au moins l'une des revendications précédentes,
**caractérisé en ce que**
l'insert électronique (20) présente une unité de connexion vers la boîte de raccordement (30).

7. Boîtier selon au moins l'une des revendications précédentes,
**caractérisé en ce que**
l'unité de connexion est réalisée de manière étanche.

8. Boîtier selon au moins l'une des revendications précédentes,
**caractérisé en ce que**
l'unité de connexion présente des broches de contact injectées pour la fonction d'étanchéité.

9. Boîtier selon au moins l'une des revendications précédentes,
**caractérisé en ce que**
l'unité de connexion est reliée à la boîte de raccordement (30) par l'intermédiaire d'un joint.

10. Boîtier selon au moins l'une des revendications précédentes,
**caractérisé en ce que**
la boîte de raccordement (30) comprend au moins une mémoire de données électronique.

11. Boîtier selon au moins l'une des revendications précédentes,
**caractérisé en ce que**
la mémoire de données électronique est réalisée de façon que des données, en particulier des données d'adresse, puissent y être mémorisées de manière durable, en particulier stable à long terme.

12. Appareil de terrain avec un boîtier selon au moins l'une des revendications précédentes, l'appareil de terrain étant réalisé pour l'utilisation décentralisée dans une installation industrielle et le boîtier comprenant au moins un insert électronique (20) et au moins une boîte de raccordement (30),
l'insert électronique (20) présentant des premiers connecteurs dans la direction de la force de gravité.

13. Appareil de terrain selon la revendication 12,
**caractérisé en ce que**
l'insert électronique (20) est relié au capot (11), en particulier à sa partie supérieure, par liaison de force.

14. Appareil de terrain selon la revendication 12,
**caractérisé en ce que**
l'insert électronique (20) est relié par liaison de forme et de force à un support de montage qui est entouré par la partie supérieure du capot (11).

15. Appareil de terrain selon au moins l'une des revendications précédentes,
**caractérisé en ce que**
la boîte de raccordement (30) présente deux connecteurs pour la liaison avec les premiers connecteurs.

16. Appareil de terrain selon au moins l'une des revendications précédentes,
**caractérisé en ce que**
la boîte de raccordement (30) présente des ouvertures pour l'amenée de câbles sur la face inférieure, donc dans la direction de la force de gravité.

17. Appareil de terrain selon au moins l'une des revendications précédentes,
**caractérisé en ce que**
la boîte de raccordement (30) est reliée au capot (11) par liaison de forme et de manière étanche.

18. Appareil de terrain selon au moins l'une des revendications précédentes,
**caractérisé en ce que**
la boîte de raccordement (30) présente deux joints pour la liaison étanche avec le capot (11).

19. Appareil de terrain selon au moins l'une des revendications précédentes,
**caractérisé en ce que**
l'insert électronique (20) comprend une fonction de variateur de fréquence ou est relié électriquement à un variateur de fréquence.
